# EUROPÄISCHE PATENTSCHRIFT

(11) **EP 0 510 349 B1**
(45) Veröffentlichungstag und Bekanntmachung des Hinweises auf die Patenterteilung: **05.06.1996**
(21) Anmeldenummer: 92104520.9
(22) Anmeldetag: 16.03.1992
(51) Int. Cl.: H01L 29/10, H01L 21/336, H01L 29/78

(54) **Verfahren zur Herstellung eines MOS-Transistors**
Method of manufacturing a MOS-transistor
Méthode de fabrication d'un transistor MOS

(30) Priorität: 26.04.1991 DE 4113755
(43) Veröffentlichungstag der Anmeldung: 28.10.1992
(73) Patentinhaber: SIEMENS AKTIENGESELLSCHAFT, D-80333 München (DE)
(72) Erfinder: Klose, Helmut, Dr., W-8000 München 83 (DE)

(56) Entgegenhaltungen:
- DE-A- 2 911 726
- PATENT ABSTRACTS OF JAPAN vol. 7, no. 276 (E-215)(1421) 9. Dezember 1983 ; & JP-A-58 157 169
- PATENT ABSTRACTS OF JAPAN vol. 10, no. 302 (E-445)(2358) 15. Oktober 1986 ; & JP-A-61 116 875
- PATENT ABSTRACTS OF JAPAN vol. 9, no. 47 (E-299)(1770) 27. Februar 1985 ; & JP-A-59 188 175
- JOURNAL OF CRYSTAL GROWTH, Bd. 95, Nr. 1-4, 11. Februar 1989, Amsterdam NL, Seiten 480-483; A.A. VAN GORKUM et al.: "Atomic layer doping (ALD) technology in Si and its application to a new structure FET"
- JAPANESE JOURNAL OF APPLIED PHYSICS, SUPPLEMENTS, Bd. 22, Nr. 22-1, 1983, Tokyo JP, Seiten 267-270; K. YAMAGUCHI et al.: 'A new short channel MOSFET with an atomic-layer-doped impurity-profile (ALD-MOSFET)'

## Beschreibung

Bei der allgemeinen Entwicklung in Richtung auf größere Packungsdichten in integrierten Schaltungen werden auch MOS-Transistoren mit reduziertem Platzbedarf benötigt. Bei der Strukturverkleinerung eines MOS-Transistors tritt auch eine Verkürzung der Gatelänge auf.

In MOS-Transistoren mit Gatelängen unter 0,25 µm werden entweder hohe Leckströme oder hohe Schwellenspannungen beobachtet. Beides ist nachteilig und für MOS-Transistoren dieser Technologiegeneration nicht tragbar.

Es ist bekannt (s. K. Yamaguchi et al; Jap. J. Appl. Phys. 22, suppl. 22-1, Seiten 267 - 270 (1983)), durch Verwendung einer deltaförmig-dotierten Schicht im Kanalbereich zwischen Source und Drain diese Nachteile zu umgehen. Die deltaförmig-dotierte Schicht stellt dabei einen Ersatz für eine Antipunch-Implantation dar.

Eine delta-dotierte Schicht weist eine Dicke von etwa 20 nm auf. Sie ist vom entgegengesetzten Leitfähigkeitstyp wie Source- und Drain-Gebiet dotiert. Sie weist eine Dotierstoffkonzentration von mehr als 10¹⁹ cm⁻³ auf. Im Vergleich zu der herkömmlichen Antipunch-Implantation, die im Substrat eine verschmierte Verteilung bildet, ist die Dotierstoffkonzentration in delta-dotierten Schichten scharf lokalisiert.

Es ist bekannt (s. A. A. van Gorkum et al; J. Crystal Growth 95, Seiten 480 - 483 (1989), MOS-Transistoren mit einer deltaförmig-dotierten Schicht mit einer MESA-Isolation herzustellen. Dabei ist jedoch die Verdrahtung schwierig. Des weiteren ist dieses Verfahren nicht geeignet, in einen Herstellprozeß für integrierte Schaltkreise höchster Packungsdichte (ULSI, Ultra large scale integration) integriert zu werden.

Der Erfindung liegt daher das Problem zugrunde, ein Verfahren anzugeben zur Herstellung eines MOS-Transistors mit einer deltaförmig-dotierten Schicht, das zur Integration in den Herstellprozeß einer ULSI integrierten Schaltung geeignet ist.

Das Problem wird erfindungsgemäß gelöst durch ein Verfahren nach Anspruch 1.

In dem erfindungsgemäßen Verfahren wird ausgenutzt, daß das Schichtwachstum beim epitaktischen Aufwachsen sehr genau kontrollierbar ist. Des weiteren wird ausgenutzt, daß beim epitaktischen Aufwachsen aus der Gasphase durch Beimischen von Dotierstoff enthaltenden Gasen in situ dotierte Schichten erzeugt werden können. Diese sind in ihrer Dotierung über die Gaskonzentration und in ihrer Dicke über das Schichtwachstum sehr genau einstellbar. Das erfindungsgemäße Verfahren hat daher den Vorteil, daß die zweite Schicht, die als deltaförmige Schicht wirkt, gut kontrollierbar in einer Dicke von z. B. 20 nm herstellbar ist. Die darüber angeordnete dritte Schicht, in der sich im fertigen Transistor der Kanal ausbildet, ist ebenfalls in ihrer Dicke über cas Schichtwachstum gut kontrollierbar einstellbar.

Es liegt im Rahmen der Erfindung, als Substrat ein Siliziumsubstrat zu verwenden und das Kanalgebiet aus Silizium zu bilden.

Durch Aufbringen einer Isolationsschicht auf die Oberfläche des Substrats und Strukturierung der Isolationsschicht, so daß sie eine Öffnung aufweist, in der die Oberfläche des Substrats freiliegt und die einen Bereich für den MOS-Transistor definiert und anschließende Bildung des Kanalgebiets durch selektive Epitaxie auf der Oberfläche des Substrats innerhalb der Öffnung, wird der MOS-Transistor selbstjustiert von einer Isolationsstruktur umgeben.

Es liegt im Rahmen der Erfindung die Gateelektrode vollständig mit einer Isolationsstruktur zu bedecken. Dabei wird die Isolationsschicht und die Isolationsstruktur aus einem Material gebildet, zu dem die erste Schicht, die zweite Schicht und die dritte Schicht selektiv ätzbar sind. In einem anisotropen Ätzschritt werden selektiv zu der Isolationsschicht und der Isolationsstruktur beiderseits der Gateelektrode bis in die erste Schicht reichende Vertiefungen erzeugt. Anschließend wird ganzflächig eine Glasschicht aufgebracht, die mit Dotierstoff vom zweiten Leitfähigkeitstyp versehen ist. In einem Temperschritt werden durch Austreiben des Dotierstoffs in die freiliegenden Oberflächen der ersten Schicht, der zweiten Schicht und der dritten Schicht das Source- und das Drain-Gebiet gebildet. Dabei muß der Temperschritt so geführt werden, daß die Dotierstoffverteilung in der zweiten Schicht, die als deltaförmige Schicht wirkt, und in der dritten Schicht im wesentlichen unverändert bleibt. Es liegt im Rahmen der Erfindung den Temperschritt in einem Kurzzeitausheilverfahren durchzuführen.

Es ist besonders vorteilhaft, die Isolationsstruktur durch Bildung einer ersten Isolationsschicht auf der Gateelektrode zu erzeugen. Die erste Isolationsschicht weist dabei mit der Gateelektrode gemeinsame, zur Oberfläche des Substrats senkrechte Flanken auf. An den Flanken werden durch ganzflächige konforme Abscheidung und anschließende anisotrope Rückätzung einer zweiten Isolationsschicht Flankenisolationen, auch Spacer genannt, erzeugt. In diesem Verfahren erfolgt die Anordnung des Source- und Drain-Gebietes zur Gateelektrode und zur Isolationsschicht selbstjustiert. Der Abstand zwischen der Gateelektrode und dem Source- bzw. Drain-Gebiet wird durch die Breite der Flankenisolationen festgelegt. Diese Breite der Flankenisolationen ist nur abhängig von der Dicke, in der die zweite Isolationsschicht abgeschieden wird. Dadurch wird auf einen Maskenschritt zur Definition von Source- und Drain-Gebiet verzichtet.

Weitere Ausgestaltungen der Erfindung gehen aus den übrigen Ansprüchen hervor.

Im folgenden wird die Erfindung anhand eines Ausführungsbeispiels und der Figuren näher erläutert.
- In Fig. 1 bis Fig. 7: sind Schritte des erfindungsgemäßen Herstellverfahrens dargestellt.
- In Fig. 8: ist eine zu Fig. 7 alternative Kontaktierungsmöglichkeit dargestellt.
- Fig. 9: zeigt den in Fig. 7 und Fig. 8 mit IX-IX bezeichneten Schnitt.

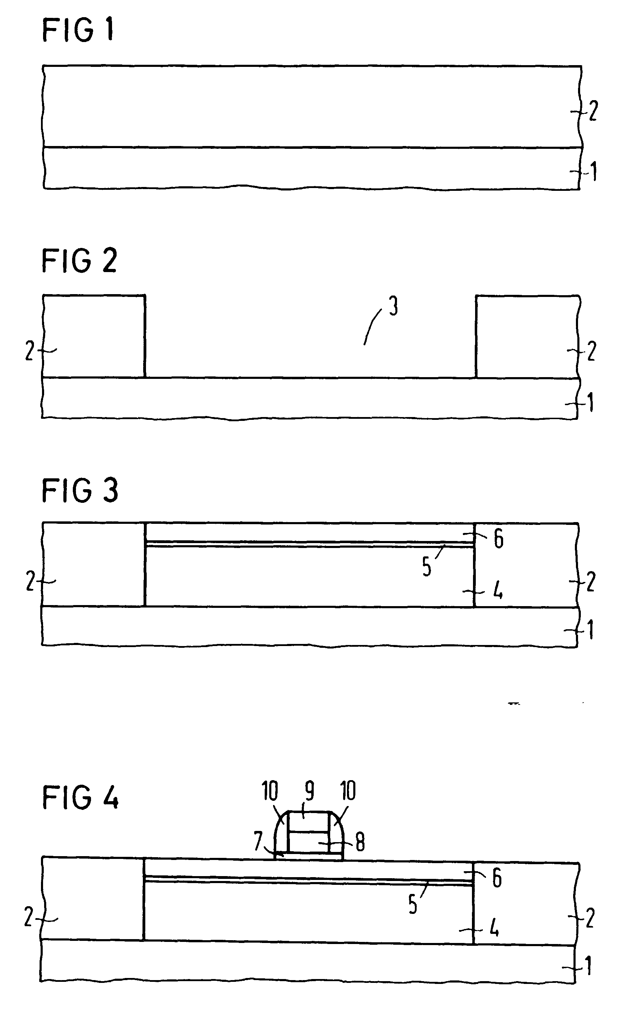

Auf einem Substrat 1 wird eine Isolationsschicht 2 aufgebracht (s. Fig. 1). Als Substrat 1 wird z. B. ein p-dotiertes Substrat aus monokristallinem Silizium mit 100-Oberflächenorientierung verwendet. Die Isolationsschicht 2 wird nach bekannten Eingangsreinigungsschritten in einer Dicke von z. B. 400 nm aus SiO₂ aufgewachsen. Dies erfolgt z. B. thermisch oder über eine Abscheidevorrichtung.

Mit Hilfe einer Photclacktechnik (nicht dargestellt) und einer anschließenden Trockenätzung wird die Isolationsschicht 2 so strukturiert, daß sie eine Öffnung 3 aufweist. Innerhalb der Öffnung 3 ist die Oberfläche des Substrats 1 freigelegt (s. Fig. 2). Die Öffnung 3 definiert einen Bereich für einen MOS-Transistor.

Anschließend wird in der Öffnung 3 eine erste Schicht 4, eine zweite Schicht 5 und eine dritte Schicht 6 so erzeugt, daß die Öffnung 3 im wesentlichen aufgefüllt ist (s. Fig. 3). Die erste Schicht 4 wird undotiert abgeschieden in einer Dicke von z. B. 300 nm. Die zweite Schicht 5 wird z. B. p-dotiert abgeschieden in einer Dicke von z. B. 20 nm. Die Dotierung erfolgt z. B. durch Zugabe von Bor in einer Konzentration von mindestens 10¹⁹ cm⁻³. Die dritte Schicht 6 wird n-dotiert abgeschieden. Sie weist eine Dicke von etwa 100 nm auf.

Anschließend wird auf die Oberfläche der dritten Schicht 6 ein Gatedielektrikum 7 aufgewachsen oder abgeschieden (s. Fig. 4). Das Gatedielektrikum 7 besteht z. B. aus SiO₂ oder aus einer Nitrid/SiO₂-Verbindung. Oberhalb des Gatedielektrikums 7 wird eine Gateelektrode 8 erzeugt. Das erfolgt z. B. durch ganzflächiger Abscheidung einer Polysiliziumschicht, die über Ionenimplantation oder Belegung dotiert wird. Auf der Polysiliziumschicht wird mit Hilfe eines CVD-Verfahrens eine Oxidschicht abgeschieden. Diese aus der Polysiliziumschicht und der Oxidschicht bestehende Doppelschicht wird phototechnisch strukturiert. Dabei entsteht die Gateelektrode 8 und eine erste Oxidschicht 9. Bedingt durch die gemeinsame Strukturierung weisen die erste Oxidschicht 9 und die Gateelektrode 8 gemeinsame, zur Oberfläche des Substrats 1 senkrechte Flanken auf. Anschließend wird eine zweite Oxidschicht konform abgeschieden. Die zweite Oxidschicht wird mit Hilfe einer Trockenätzung anisotrop rückgeätzt, so daß an beiden Seiten der Gateelektrode 9 und der ersten Oxidschicht 9 Flankenisolationen 10 aus SiO₂ entstehen. Für die Flankenisolationen 10 wird auch der Begriff Spacer verwendet. Die Breite der Flankenisolationen 10 an der Oberfläche der dritten Schicht 6 ist gegeben durch die Dicke der zweiten Oxidschicht.

Bei der Herstellung der Flankenisolationen 10 ist darauf zu achten, daß die SiO₂-Ätzung soweit überzogen wird, daß die Oberfläche der dritten Schicht 6 außerhalb der Gateelektrode 9 und der Flankenisolationen 10 vollständig freigelegt wird, so daß der blanke Siliziumkristall zum Vorschein kommt.

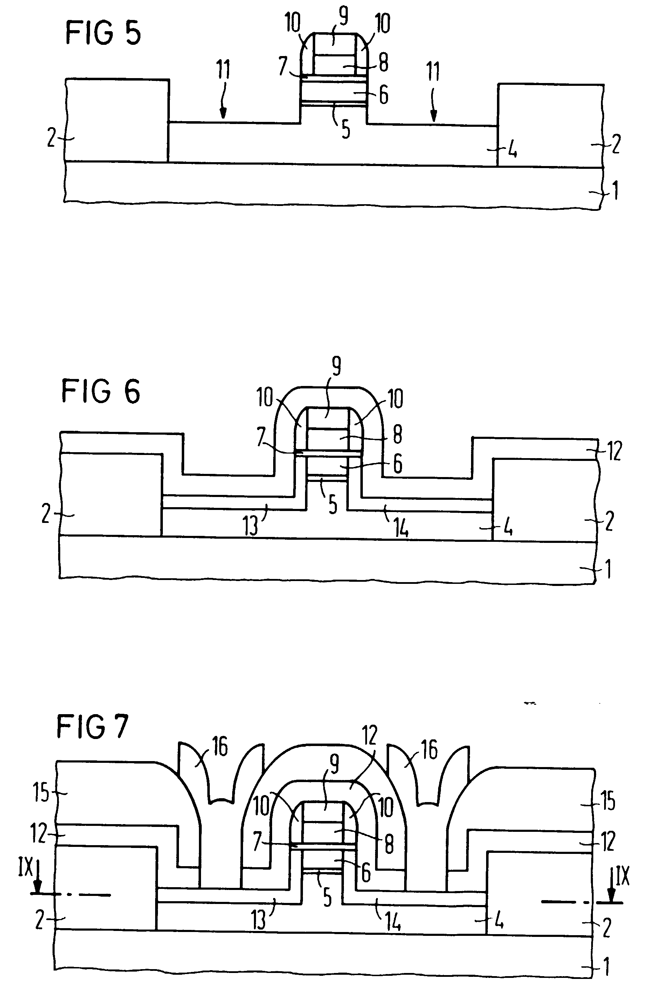

Durch eine anisotrope Siliziumätzung, die selektiv zum SiO₂ ist, werden seitlich der Gateelektrode 8 innerhalb der Isolationsschicht 2 Vertiefungen 11 erzeugt (s. Fig. 5). Die Vertiefungen 11 reichen bis in die erste Schicht 4 hinein, so daß seitlich der Flankenisolationen 10 die zweite Schicht 5 und die dritte Schicht 6 vollständig entfernt sind.

Nachfolgend wird ganzflächig eine z. B. mit Arsen dotierte Glasschicht 12 konform abgeschieden. Durch leichtes Austreiben des Dotierstoffes bei z. B. 1000 - 1050 °C während z. B. 10 sec. werden an den Oberflächen der ersten Schicht 4, der zweiten Schicht 5 und der dritten Schicht 6, die mit der Glasschicht 12 in Kontakt stehen, ein Source-Gebiet 13 und ein Drain-Gebiet 14 gebildet. Der Temperaturschritt muß so durchgeführt werden, daß die zweite Schicht 5, die als delta-dotierte Schicht wirkt, nur unwesentlich auseinanderläuft (s. Fig. 6).

Anschließend wird der MOS-Transistor durch Planarisierung, Kontaktlochätzung und Metallisierung fertiggestellt. Dies erfolgt z. B. (s. Fig. 7) durch ganzflächige Abscheidung eines Dielektrikums 15. In dem Dielektrikum 15 und der Glasschicht 12 werden oberhalb von Source-Gebiet 13 und Drain-Gebiet 14 Kontaktlöcher geöffnet, die mit Metallisierungen 16 aufgefüllt werden.

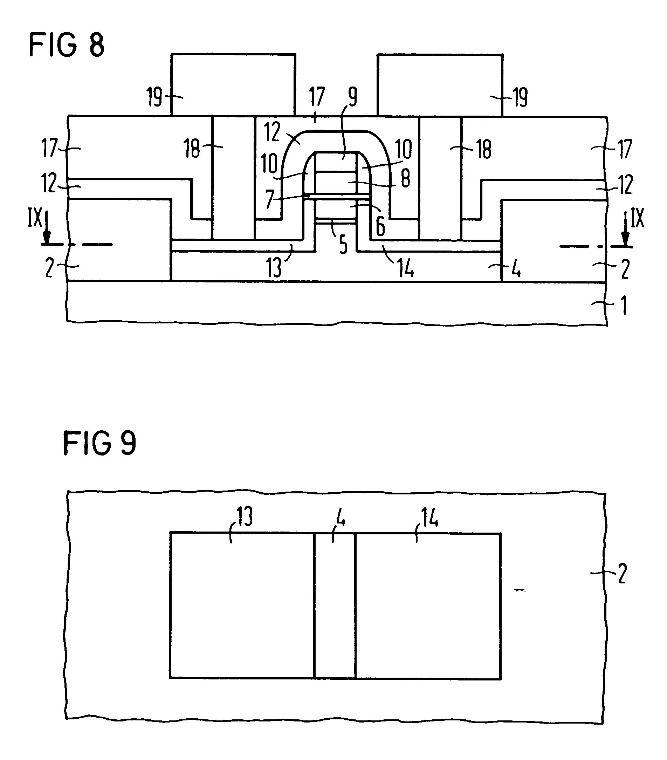

Alternativ wird der MOS-Transistor dadurch fertiggestellt, daß zunächst eine planarisierende Schicht 17 aus z. B. BPSG abgeschieden wird. In der planarisierenden Schicht 17 und der Glasschicht 12 werden Kontaktlöcher auf das Source-Gebiet 13 und das Drain-Gebiet 14 geöffnet. Die Kontaktlöcher werden mit Wolfram 18 aufgefüllt. An der Oberfläche der planarisierenden Schicht 17 werden die Wolframfüllungen 18 überdeckend Aluminiumkontakte 19 aufgebracht (s. Fig. 8).

Der in Fig. 7 und Fig. 8 mit IX-IX angedeutete Schnitt ist in Fig. 9 zu sehen. Der MOS-Transistor ist vollständig von der Isolationsschicht 2 umgeben.

Das Verfahren wurde anhand des Beispiels eines NMOS-Transistors geschildert. Es läßt sich vollkommen analog auf einen PMOS-Transistor übertragen.

## Patentansprüche

1. Verfahren zur Herstellung eines MOS Transistors mit folgenden Schritten:
a) auf die Oberfläche eines Substrats (1) aus einem von einem ersten Leitfähigkeitstyp dotierten Halbleitermaterial wird eine Isolationsschicht (2) aufgebracht,
b) die Isolationsschicht (2) wird so strukturiert, daß sie eine Öffnung (3) aufweist, in der die Oberfläche des Substrats (1) freiliegt,
c) auf der innerhalb der Öffnung (3) freiliegenden Oberfläche des Substrats (1) wird durch selektive Epitaxie eine erste Schicht (4) aufgewachsen, die undotiert ist,
d) auf die erste Schicht (4) wird durch selektive Epitaxie eine zweite Schicht (5) aufgewachsen, die von dem ersten Leitfahigkeitstyp dotiert ist und die dünner als die erste Schicht (4) ist,
e) auf die zweite Schicht (5) wird durch selektive Epitaxie eine dritte Schicht (6) aufgewachsen, die von einem zweiten, zum ersten entgegengesetzten Leitfähigkeitstyp dotiert ist und die dicker als die zweite Schicht (5) ist,
f) die erste Schicht (4), die zweite Schicht (5) und die dritte Schicht (6) bilden ein Kanalgebiet des MOS-Transistors,
g) an der Oberfläche des Kanalgebietes wird ein Gatedielektrikum (7) erzeugt,
h) an der Oberfläche des Gatedielektrikums (7) wird eine Gateelektrode (8) erzeugt,
i) die Gateelektrode (8) wird mit einer Isolationsstruktur (9, 10) vollständig bedeckt,
j) die Isolationsstruktur (9, 10) und die Isolationsschicht (2) werden aus einem Material gebildet, zu dem die erste Schicht (4), die zweite Schicht (5) und die dritte Schicht (6) selektiv ätzbar sind,
k) in einem anisotropen Ätzschritt, in dem die Isolationsstruktur (9, 10) und die Isolationsschicht (2) als Ätzmaske wirken, werden bis in die erste Schicht (4) reichende Vertiefungen (11) erzeugt,
l) es wird ganzflächig eine Glasschicht (12) aufgebracht, die mit Dotierstoff vom zweiten Leitfähigkeitstyp versehen ist,
m) in einem Temperschritt werden durch Austreiben des Dotierstoffes in die mit der Glasschicht (12) in Kontakt stehenden Oberflächen der ersten Schicht (4), der zweiten Schicht (5) und der dritten Schicht (6) das Sourcegebiet (13) und das Draingebiet (14) gebildet,
n) dabei wird der Temperschritt so geführt, daß die Dotierstoffverteilung in der zweiten Schicht (5) und in der dritten Schicht (6) im wesentlichen unverändert bleibt.

2. Verfahren nach Anspruch 1,
bei dem als Substrat (1) ein Siliziumsubstrat verwendet wird und bei dem das Kanalgebiet aus Silizium gebildet wird.

3. Verfahren nach Anspruch 1 oder 2,
bei dem als Temperschritt ein Kurzzeitausheilverfahren im Temperaturbereich von 1000 bis 1050°C während einer Dauer von etwa 10 sec angewendet wird.

4. Verfahren nach einem der Ansprüche 1 bis 3 mit folgenden Schritten:
a) zur Erzeugung der Isolationsstruktur (9, 10) wird auf der Gateelektrode (8) eine erste Isolationsschicht (9) gebildet, die mit der Gateelektrode (8) gemeinsame, zur Oberfläche des Substrats (1) senkrechte Flanken aufweist,
b) an den Flanken werden durch ganzflächige konforme Abscheidungen und anschließende anisotrope Rückätzung einer zweiten Isolationsschicht Flankenisolationen (10) (Spacer) erzeugt.

5. Verfahren nach einem der Ansprüche 1 bis 4,
bei dem die erste Schicht (4) in einer Dicke von etwa 300 nm die zweite Schicht (5) in einer Dicke von etwa 20 nm und die dritte Schicht (6) in einer Dicke von etwa 100 nm gebildet werden.

## Claims

1. Method of manufacturing a MOS transistor, having the following steps:
a) an insulation layer (2) is applied to the surface of a substrate (1) made of a semiconductor material which is doped with a first conductivity type,
b) the insulation layer (2) is structured in such a way that it has an opening (3) in which the surface of the substrate (1) is exposed,
c) a first layer (4), which is undoped, is grown by selective epitaxy upon that surface of the substrate (1) which is exposed inside the opening (3),
d) a second layer (5), which is doped with the first conductivity type and is thinner than the first layer (4), is grown by selective epitaxy upon the first layer (4),
e) a third layer (6), which is doped with a second conductivity type opposite to the first and is thicker than the second layer (5), is grown by selective epitaxy upon the second layer (5),
f) the first layer (4), the second layer (5) and the third layer (6) form a channel region of the MOS transistor,
g) a gate dielectric (7) is produced on the surface of the channel region,
h) a gate electrode (8) is produced on the surface of the gate dielectric (7),
i) the gate electrode (8) is completely covered by an insulation structure (9, 10),
j) the insulation structure (9, 10) and the insulation layer (2) are formed by a material with respect to which the first layer (4), the second layer (5) and the third layer (6) can selectively be etched,
k) depressions (11) reaching down into the first layer (4) are produced in an anisotropic etching step in which the insulation structure (9, 10) and the insulation layer (2) act as an etching mask,
l) a glass layer (12), which is provided with a dopant of the second conductivity type, is applied over the whole area,
m) the source region (13) and the drain region (14) are formed in a tempering step by driving the dopant out into those surfaces of the first layer (4), of the second layer (5) and of the third layer (6) which are in contact with the glass layer (12),
n) in this case, the tempering step is handled in such a way that the dopant distribution in the second layer (5) and in the third layer (6) remains essentially unchanged.

2. Method according to Claim 1,
in which a silicon substrate is used as the substrate (1), and in which the channel region is formed of silicon.

3. Method according to Claim 1 or 2,
in which a brief annealing process in the temperature range of 1000 to 1050°C for a duration of approximately 10 sec is employed as the tempering step.

4. Method according to one of Claims 1 to 3, having the following steps:
a) in order to produce the insulation structure (9, 10), a first insulation layer (9) is formed on the gate electrode (8), which insulation layer has edges which are shared with the gate electrode (8) and are perpendicular with respect to the surface of the substrate (1),
b) edge insulations (10) (spacers) are produced on the edges by corresponding deposition over the whole area and subsequent anisotropic etching back of a second insulation layer.

5. Method according to one of Claims 1 to 4, in which the first layer (4) is formed with a thickness of approximately 300 nm, the second layer (5) is formed with a thickness of approximately 20 nm and the third layer (6) is formed with a thickness of approximately 100 nm.

## Revendications

1. Méthode de fabrication d'un transistor MOS comportant les étapes suivantes:
a) Une couche isolante (2) est déposée à la surface d'un substrat (1) constitué d'un matériau semi-conducteur dopé par un premier type de conductibilité,
b) la couche isolante est structurée (2) de manière à présenter une ouverture (3) dans laquelle la surface de substrat (1) est dégagée,
c) à la surface dégagée du substrat (1) à l'intérieur de l'ouverture (3), une première couche (4), non dopée, est soumise à une croissance par épitaxie sélective,
d) une seconde couche (5), dopée par le premier type de conductibilité et plus mince que la première couche (4), est déposée sur la première couche (4) par épitaxie sélective,
e) une troisième couche (6), dopée par un second type de conductibilité opposé au premier, et plus épaisse que la seconde couche (5), est déposée sur la seconde couche (5) par épitaxie sélective,
f) la première (4), la seconde (5) et la troisième couche (6) constituent une zone de canal du transistor MOS,
g) un diélectrique de grille (7) est généré à la surface de la zone de canal,
h) une électrode de grille (8) est générée à la surface du diélectrique de grille (7),
i) l'électrode de grille (8) est intégralement recouverte d'une structure isolante (9, 10),
j) la structure isolante (9, 10) et la couche isolante (2) sont formées d'un matériau par rapport auquel la première couche (4), la deuxième couche (5) et la troisième couche (6) sont gravables sélectivement,
k) des renfoncements (11) pénétrant jusque dans la première couche (4) sont réalisés dans une étape d'attaque chimique anisotrope, dans laquelle la structure isolante (9, 10) et la couche isolante (2) agissent comme masque pour l'attaque chimique,
I) une couche de verre (12), dopée par le second type de conductibilité, est déposée sur toute la surface,
m) la zone de la source (13) et la zone du drain (14) sont formées dans une étape de recuit par expulsion de la substance dopante dans les surfaces de la première couche (4), de la seconde couche (5) et de la troisième couche (6) en contact avec la couche de verre (12),
n) l'étape de recuit est ici conduite de telle manière que la répartition de la substance dopante reste dans une large mesure inchangée dans la seconde couche (5) et dans la troisième couche (6).

2. Méthode selon la revendication 1,
dans laquelle un substrat en silicium est utilisé comme substrat (1) et dans laquelle la zone de canal est formée de silicium.

3. Méthode selon la revendication 1 ou 2,
dans laquelle, comme étape de recuit, un procédé de régénération brève sur une plage de température comprise de 1000 à 1050 ^{º}C est utilisée pendant une durée d'environ 10 s.

4. Méthode selon l'une des revendications 1 à 3 comportant les étapes suivantes:
a) une première couche isolante (9), qui comporte des flancs communs à l'électrode de grille (8), verticaux à la surface du substrat (1), est formée pour élaborer la structure isolante (9, 10) sur l'électrode de grille (8),
b) des isolations des flancs (10) ( "spacer") sont générées sur les flancs par des dépôts conformes sur toute la surface, suivi d'une attaque chimique en retrait anisotrope d'une seconde couche isolante.

5. Méthode selon l'une des revendications 1 à 4,
dans laquelle la première couche (4) est formée sur une épaisseur d'environ 300 nm, la seconde couche (5) sur une épaisseur d'environ 20 nm et la troisième couche (6) sur une épaisseur d'environ 100 nm.
